# EUROPÄISCHE PATENTSCHRIFT

(11) **EP 1 969 643 B1**
(45) Veröffentlichungstag und Bekanntmachung des Hinweises auf die Patenterteilung: **09.03.2011**
(21) Anmeldenummer: 06828693.9
(22) Anmeldetag: 12.12.2006
(51) Int. Cl.: H01L 31/072

(54) **AMORPH/KRISTALLINE SILIZIUM HETEROSOLARZELLE**
AMORPHOUS/CRYSTALLINE SILICON HETERO SOLAR CELL
PILE SOLAIRE HETEROGENE AU SILICIUM CRISTALLIN/AMORPHE

(30) Priorität: 13.12.2005 DE 202005019799 U
(43) Veröffentlichungstag der Anmeldung: 17.09.2008
(73) Patentinhaber: Helmholtz-Zentrum Berlin für Materialien und Energie GmbH, 14109 Berlin (DE)
(72) Erfinder: SCHMIDT, Manfred, 10369 Berlin (DE); VON MAYDELL, Karsten, 26129 Oldenburg (DE); KORTE, Lars, 10247 Berlin (DE); CONRAD, Erhard, 15748 Koblow-Ziegelei (DE)
(74) Vertreter: Rudolph, Margit
(86) Internationale Anmeldenummer: PCT/DE2006/002263
(87) Internationale Veröffentlichungsnummer: WO 2007/076816

(56) Entgegenhaltungen:
- EP-A- 1 460 693
- EP-A- 1 519 422
- WO-A-2006/111138
- DE-A1- 4 025 311
- US-A- 4 109 271
- US-A- 5 648 675
- US-A1- 2002 117 661
- A.V. SHAH ET AL.: "Thin-film silicon solar cell technology" PROGRESS IN PHOTOVOLTAICS: RESEARCH AND APPLICATIONS, Bd. 12, 2004, Seiten 113-142, XP002430878

## Beschreibung

Die Erfindung bezieht sich auf eine amorph/kristalline Silizium-Heterosolarzelle (a-Si/c-Si Heterosolarzelle), aufweisend mindestens eine kristalline Si-Absorberschicht eines Leitungstyps, bei der auf der Seite des Lichteinfalls eine amorphe Si-Emitterschicht des entgegengesetzten Leitungstyps, darauf eine transparente leitfähige TCO-Schicht und ein Frontkontakt angeordnet ist, und auf deren anderen Seite ein Rückkontakt angeordnet ist.

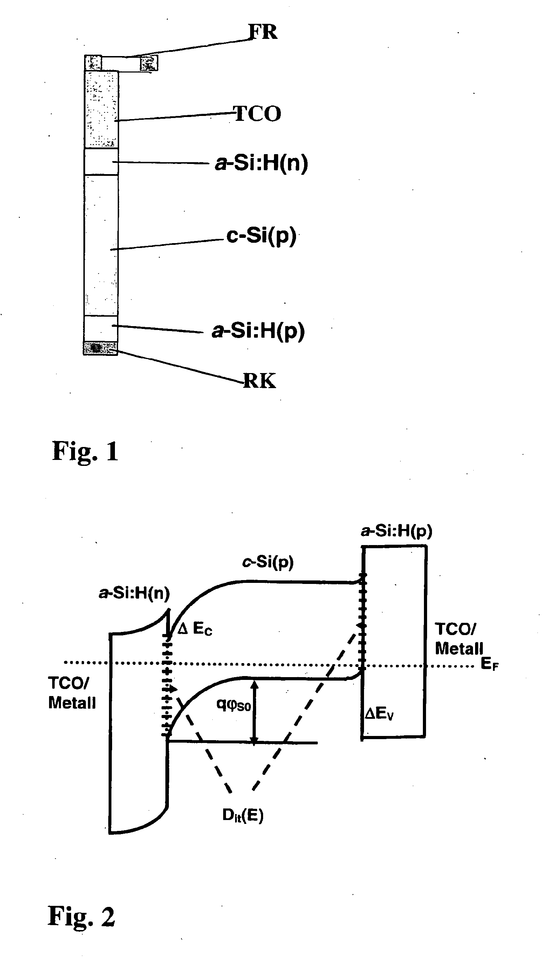

Eine derartige amorph/kristalline Silizium-Heterosolarzelle ist in US-PS 5,705,828 zum Stand der Technik (s. Fig. 1B und dazugehörige Beschreibung) beschrieben. Diese Anordnung weist eine transparente Frontelektrode, eine erste amorphe Halbleiterschicht eines Leitungstyps, eine kristalline Halbleiterschicht des entgegengesetzten Leitungstyps auf, die das durch Frontelektrode und erste amorphe Halbleiterschicht durchgehende Licht absorbieren soll. Auf der kristallinen Halbleiterschicht sind eine zweite amorphe Halbleiterschicht mit einem der ersten amorphen Halbleiterschicht entgegengesetzten Leitungstyp und ein Rückkontakt angeordnet. Dieser Veröffentlichung sind aber keine Hinweise zu entnehmen, welche Parameter (z. B. Schichtdicken, Dotierungskonzentrationen für den Typ a-Si:H(n)/c-Si(p)/a-Si:H(p)) eine derartige Schichtfolge für ihre Realisierbarkeit als a-Si/c-Si-Heterosolarzelle aufweisen muss, um die gewünschten Wirkungen zu erzielen. Die angegebene Dotierung für die umgekehrte Dotierfolge ist zu hoch und nicht optimal. Zur Verbesserung der Effizienz einer amorph/kristallinen Silizium-Heterosolarzelle ist - ausgehend von dem erwähnten Stand der Technik vorgesehen - einen zweiten Halbleiterübergang anzuordnen.

In den Veröffentlichungen US 4,109,271 A1 und "PROGRESS IN PHOTOVOLTAICS: RESEARCH AND APPLICATIONS, Bd. 12, 2004, S. 113-142, XP002430878 werden für pin-Dünnschichtsolarzellen, in denen die intrinsische amorphe Si-Schicht den Absorber bildet, Parameter für eine effiziente Solarzelle angegeben. Hierfür wird in der letztgenannten Veröffentlichung die Urbach-Energie für µc-Si:H angegeben und in der erstgenannten Veröffentlichung die Dichte der Ladungsträger für mittels Glimmentladung hergestellten Si. Diese Defektparameter (die Urbach-Energie ist der Parameter, der die Zustandsdichteverteilung in den Bandausläufern beschreibt, und die Defektdichte stellt die Anzahl der Defekte pro Volumeneinheit dar) unterscheiden sich aber von denen einer Waferbasierten a-Si/c-Si Heterostruktur-Solarzelle.

Aufgabe der Erfindung ist, eine weitere gattungsgemäße amorph/kristalline Si-Heterosolarzelle anzugeben, deren Parameter eine Verbesserung des Wirkungsgrades einer derartigen amorph/kristallinen Si-Heterosolarzelle gewährleisten.

Die Aufgabe wird durch eine eingangs genannte amorph/kristalline Si-Heterosolarzelle dadurch gelöst, dass erfindungsgemäß die amorphe Si-Emitterschicht eine geringe Defektdichte n(E) kleiner 10¹⁹ cm⁻³ aufweist und durch eine Urbach-Energie kleiner 90 meV charakterisiert ist und das Ferminiveau (E_{F}) nahe der Valenz- oder Leitungsbandkante der amorphen Si-Schicht liegt.

Bei dieser Lösung wurde die Erkenntnis genutzt, dass über die Einstellung der grundlegenden elektronischen Parameter/Eigenschaften des Hetero-übergangs - wie die Lage des Fermi-Niveaus und die Defektdichte/ Zustandsdichte in der amorphen Si-Emitterschicht - der Wirkungsgrad der beschriebenen Solarzelle wesentlich beeinflusst werden kann.

Mittels der UV-Photoelektronen-Spektroskopie (z. B. beschrieben in J. Non-Cryst. Solids 338-340, 2004, p. 211) kann die Dichte der besetzten Zustände in der verbotenen Zone sowie aus dem Spektrum die Lage des Fermi-Niveaus, das gemäß der Erfindung nahe an der die Majoritätsladungsträger der amorphen Si-Emitterschicht charakterisierenden Bandkante liegt, bestimmt werden.

Dem Stand der Technik nach kann die kristalline Si-Absorberschicht aus kristallinem (c-), multikristallinem (mc-), bandgezogenem (EFG-)Si oder kristallinem Dünnschicht-Silizium auf Glas gebildet sein.

In Ausführungsformen der Erfindung ist vorgesehen, dass im Falle einer p-leitenden kristallinen Si-Absorberschicht und einer n-leitenden amorphen Si-Emitterschicht sich das Ferminiveau nahe an der Leitungskante der amorphen Si-Sicht befindet, im Falle der inversen Struktur (kristalline Si-Absorberschicht n-leitend, amorphe Si-Emitterschicht p-leitend) befindet sich das Ferminiveau nahe an der Valenzbandkante der amorphen Si-Schicht. Das Ferminiveau liegt in beiden Fällen zwischen 0,2 eV und 0,45 eV unterhalb der Leitungsbandkante für eine n-leitende bzw. oberhalb der Valenzbandkante für eine p-leitende amorphe Silizium-Schicht.

In einer anderen Ausführungsform der Erfindung ist zwischen der kristallinen Si-Absorberschicht und dem Rückkontakt eine weitere amorphe Si-Schicht mit demselben Leitungstyp wie die kristalline Si-Absorberschicht angeordnet, wobei die weitere amorphe Si-Schicht so hochdotiert ist, dass eine Bandverbiegung in der kristallinen Si-Absorberschicht und somit eine Potentialbarriere für die Minoritätsladungsträger entsteht. Die Minoritätsladungsträger in der kristallinen Si-Absorberschicht werden an der Rückseite dieser Schicht dann praktisch reflektiert. Die Dicke dieser weiteren amorphen Si-Schicht beträgt zwischen 5 nm und 40 nm.

Die Dicke der amorphen Si-Emitterschicht beträgt zwischen 5 nm und 10 nm und die Dicke der TCO-Schicht ca. 80 nm.

Eine weitere Ausführungsform der Erfindung sieht vor, dass zwischen der weiteren amorphen Si-Schicht und dem Rückkontakt eine weitere TCO-Schicht angeordnet ist. Diese Anordnung hat zum einen den Vorteil, dass niederenergetische Photonen effektiver reflektiert werden und somit die Absorption im Absorber steigt. Zum anderen wird die a-Si:H Schicht vor der Metallschicht geschützt. Sonst könnte es zu einer Interdiffusion und somit zu unerwünschter Störstellenbildung kommen.

In einer anderen Ausführungsform der Erfindung weist die kristalline Si-Absorberschicht eine Oberflächentexturierung auf. Hierdurch wird die Reflexion der Oberfläche reduziert, was zu einer Erhöhung des Stromes in der Solarzelle führt.

Die Erfindung wird in folgendem Ausführungsbeispiel anhand von Figuren näher erläutert.

Dabei zeigen
- Fig.: 1: das Schema einer erfindungsgemäßen a-Si:H/c-Si Heterosolarzelle,
- Fig. 2:: die Bandstruktur eines Heteroüberganges einer erfindurigsgemäßen a- Si:H/c-Si-Heterosolarzelle.

Die in Fig. 1 dargestellte Solarzelle weist eine p-leitende kristalline Si-Absorberschicht **c-Si(p)** auf, auf deren einen Seite eine n-leitende 5 nm dicke amorphe Si-Emitterschicht **a-Si(n),** darauf eine 80 nm dicke TCO-Schicht **TCO** und ein Frontkontakt **FK** angeordnet ist. Auf der anderen Seite der p-leitenden kristallinen Si-Absorberschicht **c-Si(p)** ist ein Rückkontakt **RK** angeordnet. Die n-leftende amorphe Si-Emitterschicht **a-Si(n)** weist eine Defektdichte **n(E)** von 10¹⁸ cm⁻³ auf und ist durch eine Urbach-Energie von 85 meV charakterisiert. Das Ferminiveau **E_{F}** liegt nahe der Leitungsbandkante der amorphen Si-Schicht **a-Si(n).** Zwischen der kristallinen Si-Absorberschicht **c-Si(p)** und dem Rückkontakt **RK** ist eine weitere amorphe Si-Schicht, p-leitend, **a-Si(p),** mit einer Schichtdicke von 35 nm angeordnet. Diese p-leitende amorphe Si-Schicht **a-Si(p)** ist so hoch dotiert ist, dass eine Potentialbarriere für die Minoritätsladungsträger des Heteroüberganges c-Si(p)/a-Si:H(p) entsteht.

Zwischen der p-leitenden amorphen Si-Schicht **a-Si:H(p)** und dem Rückkontak **RK** kann eine weitere TCO-Schicht eingefügt werden (nicht in der Figur dargestellt).

Figur 2 zeigt die Bandstruktur eines Heteroüberganges einer a-Si:H(n)/c-Si(p)/a-Si:H(p) Heterosolarzelle. Modellrechnungen für die Effizienz einer erfindungsgemäßen Solarzelle mit einem derartigen Übergang bestätigten das Ergebnis, dass die Effizienz von den Banddiskontinuitäten für die Minoritätsladungsträger, von der Grenzflächenzustandsdichte an den Heteroübergängen zwischen den amorphen Si-Schichten **a-Si:H(n)** und **a-Si:H(p)** und der kristallinen Si-Absorberschicht **c-Si,** von der Bandverbiegung in der kristallinen Si-Absorberschicht **c-Si,** der Diffusionslänge von Minoritätsladungsträgern in der kristallinen Si-Absorberschicht **c-Si** und der Defektdichte in den amorphen Si-Schichten **a-Si:H(n, p)** abhängt.

## Patentansprüche

1. Amorph/kristalline Silizium-Heterosolarzelle aufweisend mindestens eine kristalline Si-Absorberschicht eines Leitungstyp, auf deren einen Seite unmittelbar eine amorphe Si-Emitterschicht des entgegengesetzten Leitungstyps, darauf eine TCO-Schicht und ein Frontkontakt angeordnet ist, und auf deren anderen Seite ein Rückkontakt angeordnet ist,
**dadurch gekennzeichnet, dass**
- die amorphe Si-Emitterschicht eine geringe Defektdichte n(E) kleiner 10¹⁹ cm⁻³ aufweist und durch eine Urbach-Energie kleiner 90 meV charakterisiert ist und
so daß das Ferminiveau (E_{F}) nahe der Valenz (E_{V})- oder Leitungsbandkante (E_{C}) der amorphen Si-Emitterschicht liegt.

2. Amorph/kristalline Silizium-Heterosolarzelle nach Anspruch 1,
**dadurch gekennzeichnet, dass**
die kristalline Si-Absorberschicht p-leitend (c-Si(p)) und die amorphe Si-Emitterschicht n-leitend (a-Si(n)) ist, wobei das Ferminiveau (E_{F}) nahe an der Leitungsbandkante (E_{C}) der amorphen Si-Schicht liegt und 0,2 eV < (E_{C} - E_{F}) < 0,45eV ist.

3. Amorph/kristalline Silizium-Heterosolarzelle nach Anspruch 1,
**dadurch gekennzeichnet, dass**
die kristalline Si-Absorberschicht n-leitend und die amorphe Si-Emitterschicht p-leitend ist, wobei das Ferminiveau (E_{F}) nahe an der Valenzbandkante (E_{V}) der amorphen Si-Schicht liegt und 0,2 eV < (E_{F} - E_{V}) < 0,45 eV ist.

4. Amorph/kristalline Silizium-Heterosplarzelle nach Anspruch 1,
**dadurch gekennzeichnet, dass**
zwischen der kristallinen Si-Absorberschicht und dem Rückkontakt eine weitere amorphe Si-Schicht mit demselben Leitungstyp wie die kristalline Si-Absorberschicht angeordnet ist, wobei die weitere amorphe Si-Schicht so hochdotiert ist, dass eine Potentialbarriere für die Minoritätsladungsträger entsteht.

5. Amorph/kristalline Silizium-Heterosolarzelle nach mindestens einem der Ansprüche 1 bis 4,
**dadurch gekennzeichnet, dass**
die Dicke der amorphen Si-Emitterschicht zwischen 5 nm und 10 nm und die Dicke der TCO-Schicht ca. 80 nm beträgt.

6. Amorph/kristalline Silizium-Heterosolarzelle nach Anspruch 4,
**dadurch gekennzeichnet, dass**
die Dicke der weiteren amorphen Si-Schicht mit demselben Leitungstyp wie die kristalline Si-Absorberschicht zwischen 5 nm und 40 nm beträgt.

7. Amorph/kristalline Silizium-Heterosolarzelle nach Anspruch 4,
**dadurch gekennzeichnet, dass**
sich zwischen der weiteren amorphen Si-Schicht und dem Rückkontakt eine weitere TCO Schicht befindet.

8. Amorph/kristalline Silizium-Heterosolarzelle nach Anspruch 1,
**dadurch gekennzeichnet, dass** die kristalline Si-Absorberschicht eine Oberflächentexturierung aufweist.

## Claims

1. An amorphous/crystalline silicon hetero solar cell having at least one crystalline silicon absorber layer of one conduction type, with an amorphous silicon emitter layer of the opposite conduction type arranged directly on one side thereof, on which a TCO layer and a front contact are further arranged, and on the other side of which a rear contact is arranged,
**characterized in that**
the amorphous silicon emitter layer has a low defect density n(E) of less than 10¹⁹ cm⁻³ and is **characterized by**
an Urbach energy of less than 90 meV such that the Fermi level (E_{F}) is near the valence (E_{V}) or conduction band edge (E_{C}) of the amorphous silicon emitter layer.

2. The amorphous/crystalline silicon hetero solar cell as recited in claim 1, **characterized in that** the crystalline silicon absorber layer is p-conductive (c-Si(p)) and the amorphous silicon emitter layer is n-conductive (a-Si(n)), wherein the Fermi level (E_{F}) is near the conduction band edge (Ec) of the amorphous silicon layer and 0.2 eV < (E_{C} - E_{F}) < 0.45 eV.

3. The amorphous/crystalline silicon hetero solar cell as recited in claim 1, **characterized in that** the crystalline silicon absorber layer is n-conductive and the amorphous silicon emitter layer is p-conductive, wherein the Fermi level (E_{F}) is near the valence band edge (E_{V}) of the amorphous silicon layer and 0.2 eV < (E_{F} - E_{V}) < 0.45 eV.

4. The amorphous/crystalline silicon hetero solar cell as recited in claim 1, **characterized in that** a further amorphous silicon layer of the same conduction type as the crystalline silicon absorber layer is arranged between the crystalline silicon absorber layer and the rear contact, wherein the further amorphous silicon layer is so highly doped that a potential barrier is created for minority charge carriers.

5. The amorphous/crystalline silicon hetero solar cell as recited in at least one of claims 1 to 4, **characterized in that** the thickness of the amorphous silicon emitter layer is between 5 nm and 10 nm and the thickness of the TCO layer is about 80 nm.

6. The amorphous/crystalline silicon hetero solar cell as recited in claim 4, **characterized in that** the thickness of the further amorphous silicon layer of the same conduction type as the crystalline silicon absorber layer is between 5 nm and 40 nm.

7. The amorphous/crystalline silicon hetero solar cell as recited in claim 4, **characterized in that** a further TCO layer is located between the further amorphous silicon layer and the rear contact.

8. The amorphous/crystalline silicon hetero solar cell as recited in claim 1, **characterized in that** the crystalline silicon absorber layer is furnished with surface texturing.

## Revendications

1. Pile solaire hétérogène au silicium cristallin/amorphe comportant au moins un couche absorbante de Si cristallin d'un type de conduction, sur l'une des faces de laquelle est disposée directement un couche émettrice de Si amorphe du type de conduction opposé, sur cette dernière, une couche de TCO et un contact avant et sur l'autre face est disposé un contact arrière
**caractérisée en ce que**
la couche émettrice de Si amorphe présente une densité de défauts n(E) inférieure à 10¹⁹ cm⁻³ et est **caractérisée par** une énergie d'Urbach inférieure à 90 meV,
de sorte que le niveau de Fermi (E_{F}) soit proche de la limite de la bande de valence (E_{V}) ou de la limite de la bande de conduction (E_{C}) de la couche émettrice de Si amorphe.

2. Pile solaire hétérogène au silicium cristallin/amorphe selon la revendication 1, **caractérisée en ce que** la couche absorbante au silicium cristallin est conductrice P (c-Si(p)) et la couche émettrice au silicium amorphe est conductrice N (a-Si(n)), le niveau de Fermi (E_{F}) étant proche de la limite de la bande de conduction (E_{C}) de la couche de Si amorphe et étant de 0,2 eV < (E_{C} - E_{F}) < 0,45 eV.

3. Pile solaire hétérogène au silicium cristallin/amorphe selon la revendication 1, **caractérisée en ce que** la couche absorbante au silicium cristallin est conductrice N, le niveau de Fermi (E_{F}) étant proche de la limite de la bande de valence (E_{V}) de la couche de Si amorphe et étant de 0,2 eV < (E_{F} - E_{V}) < 0,45 eV.

4. Pile solaire hétérogène au silicium cristallin/amorphe selon la revendication 1, **caractérisée en ce qu'**entre la couche absorbante de Si cristallin et la contact arrière est disposée une couche supplémentaire de Si amorphe, avec le même type de conduction que la couche absorbante de Si cristallin, la couche supplémentaire de Si amorphe étant si fortement dopée, qu'il en résulte une barrière potentielle pour les porteurs minoritaires.

5. Pile solaire hétérogène au silicium cristallin/amorphe selon au moins l'une quelconque des revendications 1 à 4, **caractérisée en ce que** l'épaisseur de la couche émettrice de Si amorphe se situe entre 5 nm et 10 nm et l'épaisseur de la couche de TCO est de 80 nm.

6. Pile solaire hétérogène au silicium cristallin/amorphe selon la revendication 4, **caractérisée en ce que** l'épaisseur de la couche supplémentaire de Si amorphe avec le même type de conduction que la couche absorbante de Si cristallin se situe entre 5 nm et 40 nm.

7. Pile solaire hétérogène au silicium cristallin/amorphe selon la revendication 4, **caractérisée en ce qu'**entre la couche supplémentaire de Si et le contact arrière se trouve une couche supplémentaire de TCO.

8. Pile solaire hétérogène au silicium cristallin/amorphe selon la revendication 4, **caractérisée en ce que** la couche absorbante de Si cristallin comporte une texture superficielle.
